# EUROPÄISCHE PATENTSCHRIFT

(11) **EP 4 381 304 B1**
(45) Veröffentlichungstag und Bekanntmachung des Hinweises auf die Patenterteilung: **10.06.2026**
(21) Anmeldenummer: 22772959.7
(22) Anmeldetag: 05.09.2022
(51) Int. Cl.: G01R 31/28, G01R 31/3185

(54) **ABSCHIRMVORRICHTUNG FÜR EINEN CHUCK, ENTSPRECHENDER CHUCK UND ENTSPRECHENDE WAFERPROBERANORDNUNG**
SHIELDING DEVICE FOR A CHUCK, CORRESPONDING CHUCK, AND CORRESPONDING WAFER PROBER ASSEMBLY
DISPOSITIF DE PROTECTION POUR MANDRIN, MANDRIN CORRESPONDANT ET ENSEMBLE MACHINE DE TEST SOUS POINTES CORRESPONDANT

(30) Priorität: 06.10.2021 DE 102021211263
(43) Veröffentlichungstag der Anmeldung: 12.06.2024
(73) Patentinhaber: ERS electronic GmbH, 82110 Germering (DE)
(72) Erfinder: REITINGER, Klemens, 82110 Germering (DE)
(74) Vertreter: Isarpatent
(86) Internationale Anmeldenummer: PCT/EP2022/074556
(87) Internationale Veröffentlichungsnummer: WO 2023/057143

(56) Entgegenhaltungen:
- JP-A- 2011 210 956
- US-A- 5 018 278
- US-A1- 2008 145 190
- US-A1- 2008 229 811

## Beschreibung

Die vorliegende Erfindung betrifft eine Abschirmvorrichtung für einen Chuck, einen entsprechenden Chuck und eine entsprechende Waferproberanordnung.

Die US 2008/229811 A1 offenbart eine Substratverarbeitungvorrichtung mit einem Chuck, der ein kontaktloses Luftlager mit Vakuumvorspannung aufweist. In einer Peripherie des Chucks ist ein Rotationsmechanismus für das Substrat vorgesehen, welcher einen Ring aufweist, der auf einer Leiste an der Oberseite des Chucks drehbar gelagert ist.

Im Fertigungsablauf bei der Produktion von integrierten Schaltungen werden Wafertests an noch nicht zerteilten Wafern durchgeführt, um fehlerhafte integrierte Schaltungen frühzeitig erkennen und aussondern zu können. Dafür wird ein zu testender Wafer in einen Waferprober eingelegt und mittels eines darin befindlichen temperierbaren Chucks auf eine gewünschte Testtemperatur gebracht. Wenn sich der Wafer auf der gewünschten Testtemperatur befindet, wird mittels einer Kontaktnadelanordnung, die sich an einem Nadelkopf befindet, eine elektrische Verbindung zu den Kontaktflächen der zu testenden integrierten Schaltung erstellt. Der Nadelkopf mit den Kontaktnadeln ist auf einer sogenannten Probecard angebracht, welche eine Schnittstelle zwischen einem Testsystem und dem Wafer über die Kontaktnadeln des Nadelkopfes bildet. Üblicherweise ist die Waferprober-Probecard mechanisch in einem Waferprober verankert und über einen Kabelstrang mit einem Testgerät verbunden. Die Waferprober-Probecard besteht üblicherweise aus einer gedruckten Schaltungsplatte (PCB), an der der Nadelkopf mit den Kontaktnadeln überstehend angebracht ist.

Zum Testen lässt sich der Chuck mit dem darauf befindlichen Wafer im Waferprober unterhalb des Nadelkopfes seitlich und in Höhenrichtung verfahren, damit sämtliche auf dem Wafer befindlichen integrierten Schaltungen, welche zu testen sind, erreicht werden können.

Derartige Wafertests werden typischerweise im Temperaturbereich zwischen -60 °C und +300 °C durchgeführt, in Ausnahmefällen sogar bei noch extremeren Temperaturen oberhalb bzw. unterhalb des Nullpunkts.

Grundsätzlich bekannt ist die Thematik der Abschirmung des zu testenden Wafers, sei es gegen Umwelteinflüsse von außen (elektrische Störungen, Licht, Feuchtigkeit, etc.), oder sei es zur bewussten Konditionierung der Wafer Umgebung (Feuchtigkeit, Temperatur, etc.).

Die DE 10 2013 215 781 A1 offenbart eine thermische Abschirmvorrichtung für einen Waferprober mit einer ersten und zweiten wärmeleitfähigen Platte, einer zwischen der ersten und zweiten wärmeleitfähigen Platte vorgesehenen strukturierten wärmeisolierenden Zwischenschicht, welche ein Kanalsystem für ein Temperierungsfluid ausbildet, welches auf einer ersten Seite durch die erste Platte und auf einer zweiten Seite durch die zweite Platte begrenzt ist, einem ersten Einlass für das Temperierungsfluid in das Kanalsystem und einem ersten Auslass für das Temperierungsfluid aus dem Kanalsystem, und einer Durchführungsöffnung zum Durchführen eines auf der Waferprober-Probecard angebrachten Nadelkopfes.

Die DE 41 09 908 A1 offenbart eine Anordnung zur Prüfung von Halbleiter-Wafern mit einem Probertisch zur Aufnahme der zu prüfenden Halbleiter-Wafer, mit einer Halterung zur Aufnahme von Sondenhaltern, wobei der Probertisch innerhalb eines Behälters angeordnet ist, der nach oben offen ausgebildet ist, wobei der nach oben offene Behälter durch eine Platte abgedeckt ist, die eine Öffnung zur Durchführung von Sonden enthält, und wobei innerhalb des Behälters Ausströmelemente vorgesehen sind, die über eine Verbindung an eine Quelle für Luft, Gas oder dergleichen angeschlossen sind.

Die DE 69 322 206 T2 offenbart eine Wafer-Prüfstation mit integrierten Einrichtungen für Erdung, Kelvinverbindung und Abschirmung, umfassend meine Spannvorrichtung zum Halten einer Testvorrichtung, einen Halter für einen elektrischen Meßfühler zum Berühren der Testvorrichtung, und einen Positioniermechanismus zum selektiven Bewegen wenigstens einer Spannvorrichtung und eines Halters hin oder weg von der/dem anderen entlang einer Heranführungsachse.

Die Spannvorrichtung weist wenigstens separate erste, zweite und dritte, elektrisch leitfähige Spannvorrichtungselemente auf, die elektrisch gegeneinander isoliert und mit fortschreitend größeren Abständen von dem Halter entlang der Heranführungsachse positioniert sind, wobei die Spannvorrichtung ferner wenigstens eine lösbare, elektrische Verbindereinrichtung zum lösbaren Aufnehmen eines Kabels von einem Testgerät aufweist, wobei die Verbindereinrichtung wenigstens zwei leitfähige Verbinderelemente aufweist, die elektrisch gegeneinander isoliert sind, jedes der Verbinderelemente ineinandergreifend mit einem jeweiligen anderen der ersten und zweiten Spannvorrichtungselementen elektrisch verbunden und nicht mit dem dritten Spannvorrichtungselement elektrisch verbunden ist, und wobei jedes der Spannvorrichtungselemente ferner wenigstens eine Oberfläche aufweist, die zu einer Oberfläche eines anderen der Spannvorrichtungselemente gerichtet ist.

Die Spannvorrichtung weist ferner dielektrische, zwischen jeweiligen Oberflächen der jeweiligen Spannvorrichtungselemente angeordnete Abstandshalter auf, wobei sich die Abstandshalter lediglich über geringe Abschnitte der Oberfläche erstrecken und dadurch zwischen den gegenüberliegenden Flächen Luftspalte über größere Abschnitte ihrer jeweiligen Oberflächen freilassen.

Die EP 2 659 279 B1 offenbart eine Vorrichtung zum elektrischen Hochspannungsprüfen von einem Halbleiterwafer umfassend eine Druckkammer, deren Innenraum über eine Druckgasleitung unter Überdruck gesetzt werden kann, wobei die Druckkammer an einer Nadelkarte mit Prüfnadeln angeordnet ist, wobei die Druckkammer wenigstens einen Teil aufweist, der relativ zur Nadelkarte beweglich ist und wobei zwischen der dem Halbleiter-wafer zugekehrten Stirnfläche des beweglichen Teils der Druckkammer und dem Halbleiter-wafer ein Spalt, in dem ein Luftlager ausgebildet ist, vorgesehen ist.

Das Waferproben kann in zwei Kategorien unterteilt werden, und zwar das sogenannte analytische Waferproben und das sogenannte "Produktions- oder vollautomatische Waferproben. Beim analytischen Waferproben kommen mehr manuelle und halbautomatische Maschinen zum Einsatz, da es hier mehr um einen Erkenntnisgewinn als um produktiven Durchsatz geht, im vollautomatischen Waferprobern geht es um Gut/Schlecht-Entscheidung, Durchsatz und Automatisierung. Schätzungen gehen davon aus, dass es heute ca. 20% analytische und 80% vollautomatische Waferprober-Anwendungen in der Industrie gibt.

Dementsprechend ist das Marktvolumen für das vollautomatische Proben deutlich größer. Keine der bekannten Lösungen ist jedoch für das vollautomatische Waferproben auf Produktionsebene brauchbar.

Daher ist der Bedarf an einer gleichwertigen Abschirmungslösung auf Produktionsebene sehr hoch.

Die bekannte Lösung der DE 69 322 206 T2 ist für das vollautomatische Waferproben nicht anwendbar, da diese zu aufwändig und damit zu teuer ist sowie aus Abschirmelementen besteht, die in einem vollautomatischen Waferprober nicht einzusetzen sind (z.B. Metall-Abschirmblenden, die dem Dauerbetrieb in der Produktion nicht standhalten, etc.).

Die bekannte Lösung der DE 41 09 908 A1 erbringt das Problem, das der nach oben geöffnete Deckel sich während des Probens zwangsläufig unterhalb des zu testenden Wafers befindet. Ansonsten bestünde die Gefahr, die sehr teure Prüfkarte zu beschädigen. Der zu testende Wafer ist also in genau dem Moment ungeschützt, während der Test stattfindet. Somit ist die zweite, bekannte Lösung ebenfalls unbrauchbar, um eine komplette Abschirmung des Wafers oder eine bewusste Konditionierung des Raumes um den Wafer, zu erreichen.

Die bekannte Lösung der EP 2 659 279 B1 erzeugt einen Luftstrom auf der Waferoberfläche, welcher zu thermischen Inhomogenitäten und zu unerwünschtem Partikeltransport führt.

Aus genannten Gründen haben sich alle bekannten Konzepte daher bis heute nicht im Bereich des vollautomatischen Waferprobens etabliert.

Daher ist es Aufgabe der vorliegenden Erfindung, eine Abschirmvorrichtung für einen Chuck, einen entsprechenden Chuck und eine entsprechende Waferproberanordnung zu schaffen, welche produktionstauglich, zuverlässig und wirtschaftlich sind.

Zur Lösung dieser Aufgabe schafft die vorliegende Erfindung eine Abschirmvorrichtung für einen Chuck gemäß dem unabhängigen Anspruch 1, einen Chuck gemäß dem Anspruch 9 sowie eine Waferproberanordnung gemäß dem Anspruch 10.

In den Unteransprüchen finden sich vorteilhafte Weiterbildungen und Verbesserungen des betreffenden Gegenstandes der Erfindung.

Die der vorliegenden Erfindung zugrundeliegende Idee besteht darin, dass die Abschirmvorrichtung mit einer Ringeinrichtung mit einem ersten Ring und einem zweiten Ring ausgestattet ist, welche ein Abschirmvolumen bilden können. Der erste Ring ist an einer äußeren Peripherie von dem Chuck anbringbar, wobei der zweite Ring entlang einer Höhenachse des Chucks verschieblich zum ersten Ring an dem ersten Ring gelagert ist.

Eine Vorspanneinrichtung ist vorgesehen, welche zum elastischen Vorspannen des zweiten Ringes gegenüber dem ersten Ring entlang der Höhenachse des Chucks dient, so dass der zweite Ring in dem Chuck im angebrachten Zustand über die Oberseite des Chuck vorsteht. Der zweite Ring weist einen Hohlraum und damit kommunizierende Bohrungen auf, wobei der Hohlraum einen Anschluss zum Anschließen einer Gasversorgungseinrichtung aufweist. Über die Bohrungen mittels der Gasversorgungseinrichtung ist ein Luftlager gegenüber einem plattenförmigen Gegenlager oberhalb des zweiten Ringes in Bezug auf die Höhenachse des Chucks erzeugbar, wobei die Vorspanneinrichtung durch das Luftlager derart komprimierbar ist, dass keine Berührung zwischen dem zweiten Ring und dem plattenförmigen Gegenlager auftritt.

Die erfindungsgemäße Abschirmvorrichtung für einen Chuck, der entsprechende Chuck und die entsprechende Waferproberanordnung weisen den Vorteil auf, dass sie sich zur Nachrüstung in handelsüblichen Waferprobern eignen und leicht montierbar bzw. demontierbar sind. Weiterhin lässt sich die erfindungsgemäße Abschirmvorrichtung vorzugsweise mit Luft als Arbeitsfluid betreiben, wobei diese Luft auch für ein entsprechendes Chucksystem des Waferprobers verwendet werden kann. Mit anderen Worten ist bei derartigen Waferprobern die Quelle für das Arbeitsfluid in Form von Luft bereits vorhanden, und es müssen bei Nachrüstung lediglich weitere Anschlüsse bzw. Regelungsmodule für die Abschirmvorrichtung bereitgestellt werden.

Erfindungsgemäß ist der zweite Ring an einer vom Chuck abgewandten oder dem Chuck zugewandten lateralen Seite des ersten Ringes verschieblich gelagert, welche im Wesentlichen parallel zur äußeren Peripherie des Chucks verläuft. Ein derartiger Aufbau lässt sich einfach realisieren.

Gemäß einer weiteren bevorzugten Weiterbildung ist der zweite Ring in einer Aussparung des ersten Ringes verschieblich gelagert. Ein derartiger Aufbau ist besonders platzsparend.

Erfindungsgemäß ist zwischen zweiten Ring und dem ersten Ring eine im Wesentlichen fluiddichte Gleitlagereinrichtung vorsehen. Dies ermöglicht eine besonders effektive Abschirmung.

Gemäß einer weiteren bevorzugten Weiterbildung weist die Vorspanneinrichtung eine Federeinrichtung aufweist, welche sich auf dem ersten Ring und dem zweiten Ring abstützt.

Gemäß einer weiteren bevorzugten Weiterbildung weist die Vorspanneinrichtung eine pneumatische Hubeinrichtung auf, über die der zweite Ring gegenüber dem ersten Ring anhebbar und absenkbar ist. Dies verbessert die Zugänglichkeit für einen automatischen Waferhandler.

Gemäß einer weiteren bevorzugten Weiterbildung ist die pneumatische Hubeinrichtung an dem ersten Ring angebracht und über eine Hubstange mit dem zweiten Ring verbunden.

Gemäß einer weiteren bevorzugten Weiterbildung ist eine Anschlageinrichtung vorgesehen, welche eine Verschiebung des zweiten Ringes entlang einer Höhenachse des Chucks zum ersten Ring begrenzt. Dies sorgt für eine stabile Endlage des zweiten Ringes.

Gemäß einer weiteren bevorzugten Weiterbildung ist die Anschlageinrichtung verstellbar. Dies erhöht die Flexibilität.

Gemäß einer weiteren bevorzugten Weiterbildung ist die Ringeinrichtung aus einem elektrischen oder magnetischen Abschirmmaterial gebildet ist. Somit kann eine mehrfache Funktionalität der Abschirmung erreicht werden.

Ausführungsbeispiele der Erfindung sind in den Zeichnungen dargestellt und in der nachfolgenden Beschreibung näher erläutert.

Es zeigen:
- Fig. 1a) - c): eine Waferproberanordnung mit einer Abschirmvorrichtung gemäß einer ersten Ausführungsform der vorliegenden Erfindung, und zwar Fig. 1a) als Querschnittsdarstellung, Fig. 1b) als Teildarstellung der Draufsicht auf den Chuck und Fig. 1c) als Teildarstellung eines Querschnitts durch den zweiten Ring der Ringeinrichtung;
- Fig. 2: eine Querschnittsdarstellung einer Waferproberanordnung mit einer Abschirmvorrichtung gemäß einer zweiten Ausführungsform der vorliegenden Erfindung;
- Fig. 3: eine Querschnittsdarstellung einer Waferproberanordnung mit einer Abschirmvorrichtung gemäß einer dritten Ausführungsform der vorliegenden Erfindung;
- Fig. 4: eine Querschnittsdarstellung einer Waferproberanordnung mit einer Abschirmvorrichtung gemäß einer vierten Ausführungsform der vorliegenden Erfindung;
- Fig. 5: eine Querschnittsdarstellung einer Waferproberanordnung mit einer Abschirmvorrichtung gemäß einer fünften Ausführungsform der vorliegenden Erfindung; und
- Fig. 6: eine teilweise Querschnittsdarstellung einer Waferproberanordnung mit einer Abschirmvorrichtung gemäß einer sechsten Ausführungsform der vorliegenden Erfindung.

In den Figuren bezeichnen gleiche Bezugszeichen gleiche oder funktionsgleiche Bestandteile.

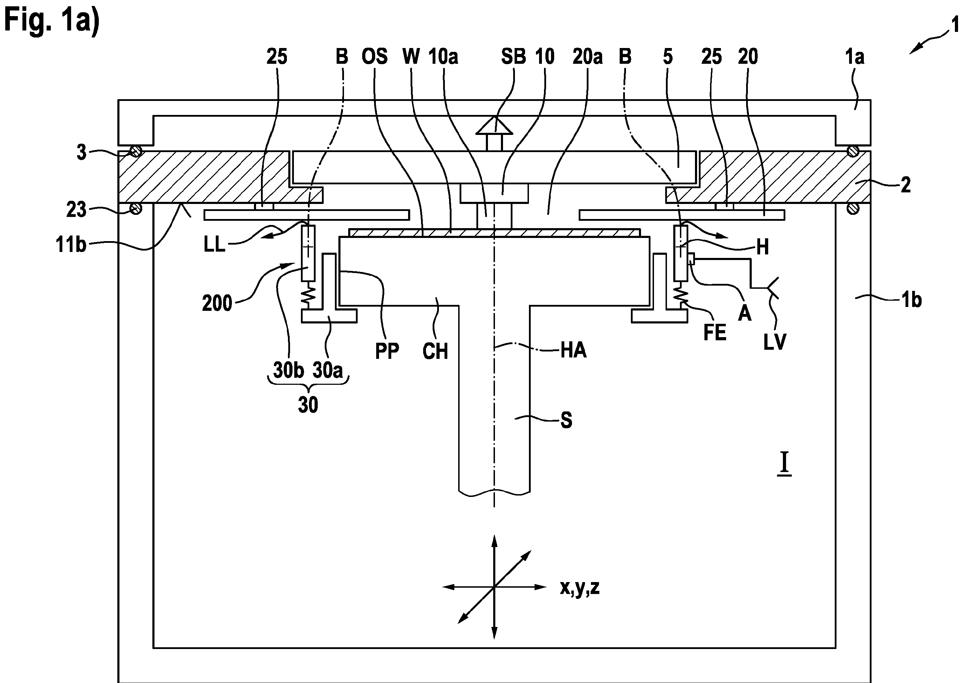

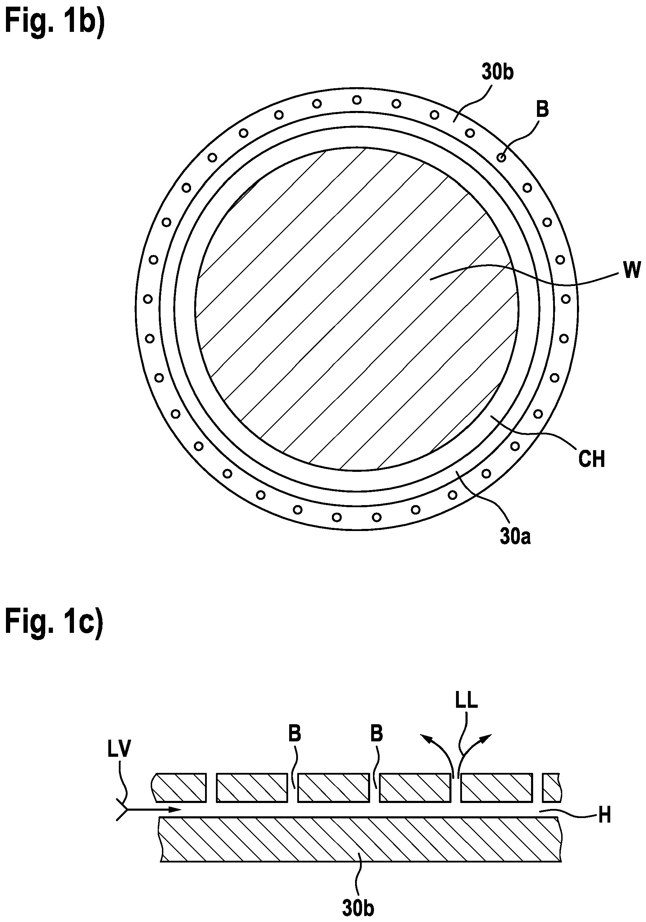

Fig. 1a) - c) zeigen eine Waferproberanordnung mit einer Abschirmvorrichtung gemäß einer ersten Ausführungsform der vorliegenden Erfindung, und zwar Fig. 1a) als Querschnittsdarstellung, Fig. 1b) als Teildarstellung der Draufsicht auf den Chuck und Fig. 1c) als Teildarstellung eines Querschnitts durch den zweiten Ring der Ringeinrichtung.

In Fig. 1 bezeichnet Bezugszeichen 1 einen Waferprober, welcher ein Oberteil 1a und ein Unterteil 1b aufweist. Das Oberteil 1a ist bezüglich des Unterteils 1b aufklappbar bzw. abnehmbar und gegenüber letzterem mittels einer Dichteinrichtung 3 abgedichtet.

Im Unterteil 1b des Waferprobers 1 befindet sich ein Chuck CH, welcher mittels einer (nicht dargestellten) Temperierungseinrichtung temperierbar ist. Der Chuck CH befindet sich auf einem Sockel S, welcher über eine programmierbare Steuerung in x-, y- und z-Richtung verfahrbar ist, wobei die Höhenverstellrichtung bzw. z-Richtung durch die Höhenachse HA des Chucks definiert ist. Im Unterteil 1b vorgesehen sind elektrische Anschlüsse und fluidische Anschlüsse für den Chuck CH und den Innenraum I, welche aus Gründen der Übersichtlichkeit vorliegend nicht dargestellt sind.

Auf die Oberseite OS des Chucks CH aufgespannt ist ein zu testender Wafer W mit einer Vielzahl von zu testenden Chips.

Im oberen Bereich des Unterteils 1b aufgehängt ist eine Probecard 5 in Form einer gedruckten Schaltungsplatte, welche in einer stufenförmigen Halterung 2 des oberen Bereichs eingeschraubt oder anderweitig befestigt ist. Die Halterung 2 ist üblicherweise aus Aluminium oder Stahl gefertigt, wie auch die tragenden Teile des Waferprobers 1.

Auf der dem Innenraum I des Waferprobers 1 zugewandten Seite der Probecard 5 befindet sich ein Nadelkopf 10 mit einer daran angebrachten Nadeleinrichtung 10A zum Kontaktieren elektronischer Schaltungen auf dem Wafer W. Der Nadelkopf 10 mit der Nadeleinrichtung 10A steht von der Probecard 5 nach unten in den Innenraum I hinein vor.

Auf der dem Innenraum I abgewandten Seite der Probecard 5 befindet sich ein Signalleitungsbus SB, über den die Testsignale von der Probecard 5 an einen entsprechenden (nicht dargestellten) Tester weitergeleitet werden.

Unterhalb der Halterung 2 mit der darin eingespannten Probecard 5 vorgesehen ist eine Abschirmvorrichtung 200 gemäß der ersten Ausführungsform vorgesehen, die eine Abschirmplatte 20 aufweist, welche wie der obere Bereich eine Durchgangsöffnung 20a für den Nadelkopf 10 mit der Nadeleinrichtung 10A aufweist und welche über eine dichtende Befestigungseinrichtung 25 mit dem oberen Bereich verbunden ist.

Weiterhin weist die Abschirmvorrichtung 200 eine zweiteilige Ringeinrichtung 30 auf, die einen inneren ersten Ring 30a und einen äußeren zweiten Ring 30b aufweist. Der innere erste Ring 30a ist fest und im Wesentlichen fluiddicht um den Chuck CH herum an einer äußeren Peripherie PP des Chucks CH angebracht, z.B. angeschraubt, und weist einen Durchmesser auf, der etwas größer als der Durchmesser des Chucks CH ist.

Der äußere zweite Ring 30b ist zu dem inneren ersten Ring 30a in vertikaler Achse, d.h. in Höhenverstellrichtung z des Chucks CH, verschiebbar angebracht, beispielsweise über eine (nicht dargestellte) im wesentlichen fluiddichte Gleitlagereinrichtung.

Zwischen dem inneren ersten Ring 30a und dem äußeren zweiten Ring 30b ist eine elastische Vorspanneinrichtung vorgesehen, welche bei der ersten Ausführungsform als Federeinrichtung FE ausgebildet ist. Die Vorspanneinrichtung bzw. Federeinrichtung FE spannt den äußeren Ring 30b elastisch in vertikaler Achse, d.h. in Höhenverstellrichtung z des Chucks CH, vor, so dass er über die Oberseite des aufgelegten Wafers W in Richtung der Abschirmplatte 20 übersteht.

Die Darstellung in Fig. 1 zeigt den Chuck CH in seiner oberen Endlage, in der die Nadeleinrichtung 10a auf entsprechende Kontaktflächen eines zu testenden Chips des Wafers W aufgesetzt sind. Diese obere Endlage ist durch die Nadellänge und weitere Designparameter des Nadelkopfes 10 vorgegeben und lässt sich in der Steuerung vorprogrammieren.

Es ist aus Fig. 1 ersichtlich, dass die obere Endlage schwimmend gestaltet ist, was dadurch erreichbar ist, dass im oberen Teil des beweglichen äußeren zweiten Ringes 30b ein ringförmiger Hohlraum H mit vielen kleinen Bohrungen B eingebracht ist. Diese Bohrungen B sind nach oben in Höhenverstellrichtung z des Chucks CH zur Abschirmplatte 20 gerichtet. Der Hohlraum H ist über einen ensprechenden Anschluss A mit einer separaten Luftzufuhreinrichtung LV versehen.

Die von der Luftzufuhreinrichtung LV den Bohrungen B zugeführte Luft wirkt wie ein Luftlager LL nach oben hin, welches auf die Abschirmplatte 20 wirkt, welche so groß dimensioniert ist, dass der obere Teil des äußeren zweiten Ringes 30b immer, d.h. in jeder Messposition, mittels des Luftlagers LL dagegen gedrückt werden kann, wobei die Vorspanneinrichtung bzw. Federeinrichtung FE entsprechend komprimiert werden kann.

Entsprechend gewählt bzw. gestaltet ist die Fluiddichtigkeit zwischen dem inneren ersten Ring 30a und dem äußeren zweiten Ring 30b sowie zwischen dem inneren ersten Ring 30a und dem Chuck CH.

Umgekehrt expandiert die Vorspanneinrichtung bzw. Federeinrichtung FE, wenn der Chuck CH in seine untere Endlage gefahren wird, beispielsweise um einen automatischen Wechsel des Wafers W durch einen automatischen Handler vorzunehmen.

Somit ist der zu testende Wafer W bis auf den sehr kleinen Luftlagerspalt (üblicherweise im µm-Bereich) komplett von der Abschirmvorrichtung 200 umschlossen und damit abgeschirmt. Das Luftlager LL und die federnde Lagerung des äußeren zweiten Ringes 30b über die Vorspanneinrichtung bzw. Federeinrichtung FE ermöglichen diese volle Umschließung bei entsprechender Dimensionierung des Verschiebewegs auch bei unterschiedlichen Arbeitshöhen des Chucks CH, welche z.B. bei unterschiedlichen Nadellängen bzw. Bauformen der Nadeleinrichtung 10A auftreten können oder durch die kleine, meist 0,5mm lange, vertikale Hubbewegung, die notwendig ist, um den Kontakt zwischen Nadeln der Nadeleinrichtung 10A und dem Wafer W beim Verfahren zum nächsten Chip zu trennen.

Die Fläche der Abschirmplatte 20 um die Probecard 5 herum wird möglichst eben gestaltet. Die Abschirmplatte 20 hat damit den Vorteil, dass die Gestaltung und vor allem Oberflächenbehandlung an einem kleinen Teil (Abschirmplatte 20) einfacher und wirtschaftlicher zu gestalten ist also im inneren oberen Bereich des Innenraums I.

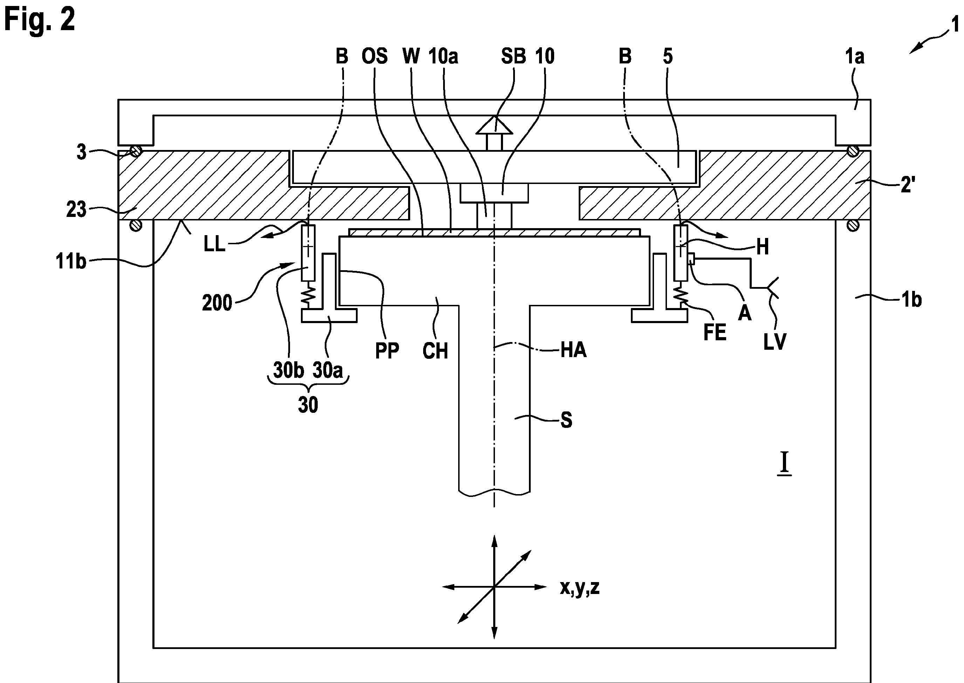

Bei bestimmten Designs kann die Abschirmplatte 20 jedoch auch entfallen (vgl. Fig. 2).

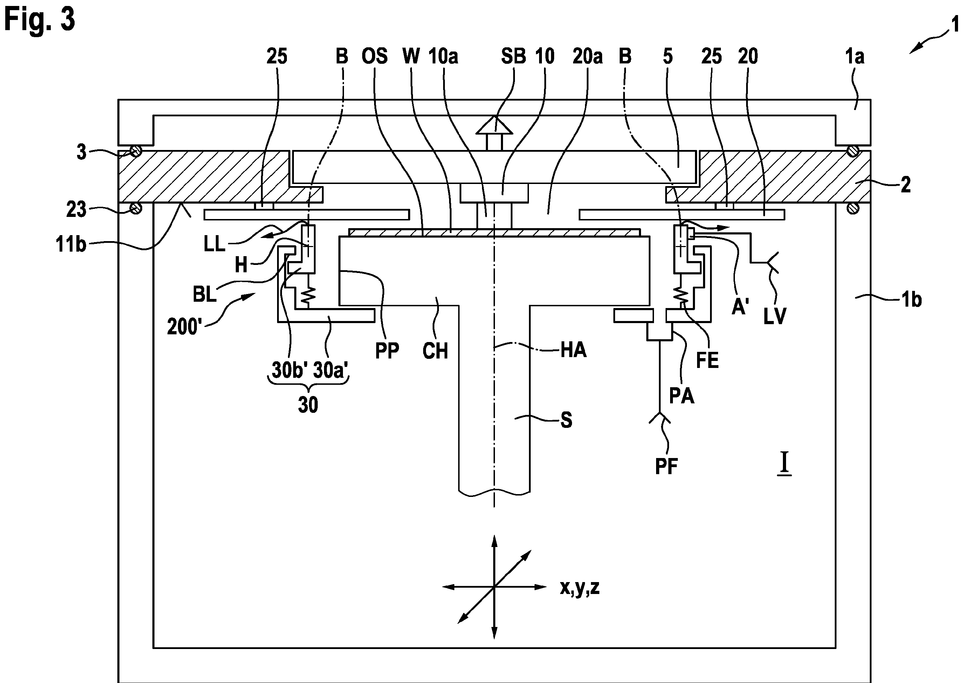

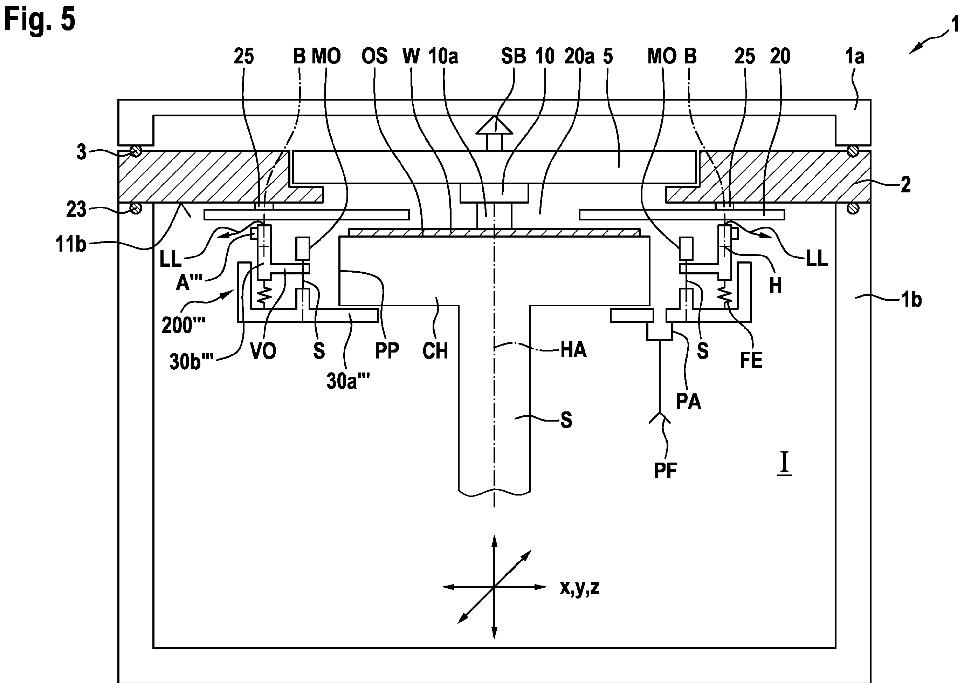

Mit Hilfe des Luftlagers LL, das sich gegen diese Abschirmplatte 20 als plattenförmiges Gegenlager relativ dicht anschmiegt, kann nun während des eigentlichen Wafertests um den Chuck CH herum eine kontrollierte Umgebung erzeugt werden. Dies kann in allen nur denkbaren Varianten geschehen. Zum Beispiel kann trockene Luft zur Herstellung eines guten Drucktaupunktens der Abschirmvorrichtung mittels (bei der ersten Ausführungsform nicht dargestellter, vgl. Fig. 3 und 5) Leitungen zugeführt werden, die aber auch der Zuführung von anderen Prozessgasen dienen können.

Eine andere Art der Abschirmung könnte eine elektrische Abschirmung sein. Die Teile der Abschirmvorrichtung 200 können aus einem elektrisch leitfähigem Material hergestellt werden. Dadurch können diese auf Shield oder Guard Potential in einer triaxialen Anwendung gelegt werden. Dies ermöglicht weit störungsfreiere Messungen als bisher bei relativ großen Abschirmvorrichtungen bzw. -kammern, die letztendlich nichts anderes als die Proberau-ßenwände sein konnten.

Wiederum eine andere Art der Abschirmung ist eine magnetische Abschirmung. Die Teile der Abschirmvorrichtung 200 können aus magnetisch schützendem Material, wie zum Beispiel Mü-Metall, herstellt werden. Dadurch können magnetische Störeinflüsse auf den zu testenden Wafer W abgeschirmt werden, z.B. das Erdmagnetfeld.

Wiederum eine andere Art der Abschirmung könnte eine thermische Abschirmung sein. Speziell bei Wafertests unter extrem hohen oder tiefen Temperaturen ist die Umgebungsluft oft ein Störfaktor für eine gute Temperaturgenauigkeit, wenn die Temperaturdifferenz zwischen Umgebungsluft und Wafer sehr hoch. Dies könnte durch Aufheizen oder Abkühlen des Raumes innerhalb der Abschirmvorrichtung verbessert werden.

Fig. 2 zeigt eine Querschnittsdarstellung einer Waferproberanordnung mit einer Abschirmvorrichtung gemäß einer zweiten Ausführungsform der vorliegenden Erfindung.

Bei der zweiten Ausführungsform ist das plattenförmige Gegenlager durch die Innenfläche 11b des oberen Bereichs des Unterteil 1b gebildet, so dass die Abschirmplatte 20 entfällt. Dies ist dadurch realisierbar, dass die Halterung 2' für die Probecard 5 im oberen Bereich des Unterteils 1b im Vergleich zur ersten Ausführungsform unterschiedlich gestaltet ist.

Ansonsten ist die zweite Ausführungsform analog zur ersten Ausführungsform ausgestaltet.

Fig. 3 zeigt eine Querschnittsdarstellung einer Waferproberanordnung mit einer Abschirmvorrichtung gemäß einer dritten Ausführungsform der vorliegenden Erfindung.

Die Abschirmvorrichtung 200' der dritten Ausführungsform unterscheidet sich von der Abschirmvorrichtung der ersten und zweiten Ausführungsform. Sie weist eine Ringeinrichtung 30' mit einem ersten Ring 30a' und einem zweiten Ring 30b' auf.

Am ersten Ring 30a' und am zweiten Ring 30b' ist eine Anschlageinrichtung BL in Form von Stufenprofilen vorgesehen, welche eine Verschiebung des zweiten Ringes 30b' entlang einer Höhenachse HA des Chucks CH zum ersten Ring 30a' begrenzt.

Durch eine derartige endlagenkontrollierte Bewegung des zweiten Ringes 30b' kann sichergestellt werden, dass es keine unerwünschte Kollision des zweiten Ringes 30b' mit der Probecard 5 bzw. der Abschirmplatte 20 geben kann.

Aufgrund der Anschlageinrichtung BL ist zudem der Anschluss A' für die Gasversorgungseinrichtung LV an anderer Stelle am zweiten Ring 30b' angebracht als bei der ersten und zweiten Ausführungsform.

Ansonsten ist die dritte Ausführungsform analog zur ersten Ausführungsform ausgestaltet.

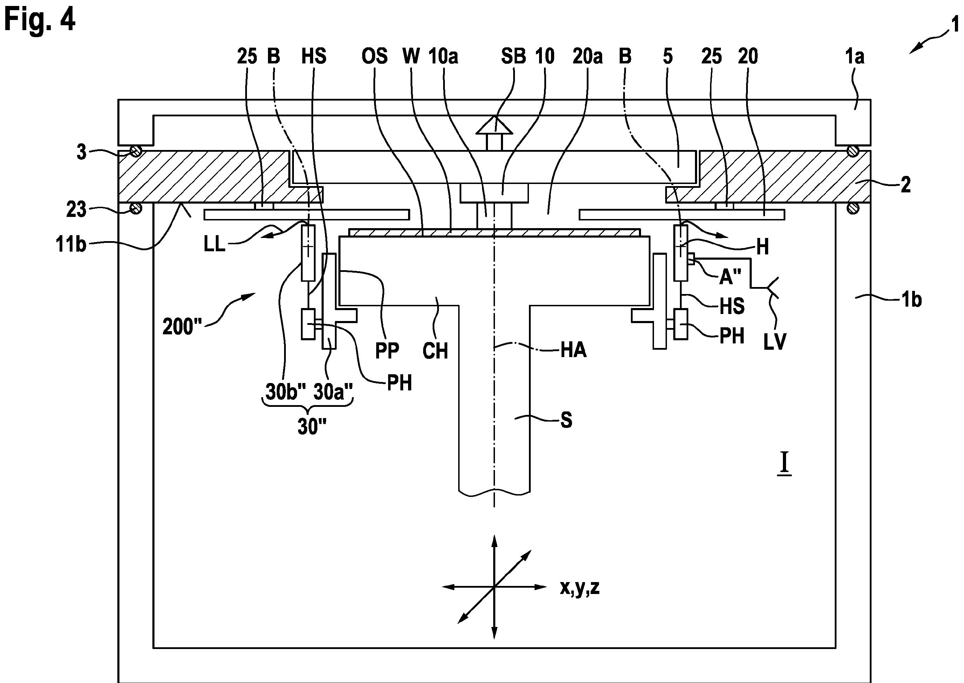

Fig. 4 zeigt eine Querschnittsdarstellung einer Waferproberanordnung mit einer Abschirmvorrichtung gemäß einer vierten Ausführungsform der vorliegenden Erfindung.

Die Abschirmvorrichtung 200" der vierten Ausführungsform unterscheidet sich von der Abschirmvorrichtung der ersten und zweiten Ausführungsform. Sie weist eine Ringeinrichtung 30" mit einem ersten Ring 30a" und einem zweiten Ring 30b" auf.

Die Abschirmvorrichtung 200" verfügt über eine Vorspanneinrichtung mit einer pneumatische Hubeinrichtung PH, über die der zweite Ring 30b" gegenüber dem ersten Ring 30a" anhebbar und absenkbar ist. Dies lässt sich beispielsweise durch einen (nicht dargestellten) Kolben realisieren, welcher mit einem Luftpolster als Federeinrichtung oder einer Federeinrichtung wechselwirkt.

Die pneumatische Hubeinrichtung PH ist an dem ersten Ring 30a" angebracht und über eine Hubstange mit dem zweiten Ring verbunden.

Ansonsten ist die dritte Ausführungsform analog zur ersten Ausführungsform ausgestaltet.

Fig. 5 zeigt eine Querschnittsdarstellung einer Waferproberanordnung mit einer Abschirmvorrichtung gemäß einer fünften Ausführungsform der vorliegenden Erfindung.

Die Abschirmvorrichtung 200‴ der fünften Ausführungsform unterscheidet sich von der Abschirmvorrichtung der ersten und zweiten Ausführungsform. Sie weist eine Ringeinrichtung 30‴ mit einem ersten Ring 30a‴ und einem zweiten Ring 30b‴ auf.

Wie bei der zweiten Ausführungsform ist eine Anschlageinrichtung MO vorgesehen ist, welche eine Verschiebung des zweiten Ringes 30b‴ entlang der Höhenachse HA des Chucks CH zum ersten Ring 30a‴ begrenzt.

Die die Anschlageinrichtung MO ist jedoch bei der fünften Ausführungsform verstellbar. Dies lässt sich dadurch realisieren, dass die Anschlageinrichtung einen Elektromotor aufweist, dessen Gehäuse als Anschlag dient. Der zweite Ring 30b‴ weist einen Vorsprung VO auf, durch den eine von dem Elektromotor drehbare Stange S gleitend geführt ist. Die Stange S weist an ihrem Ende ein Gewinde auf, das mit einem Gewinde im darunterliegenden Bereich des ersten Ringes 30a‴ in Wirkverbindung steht. So lässt sich der Anschlag in seiner Höhe anheben bzw. absenken und damit die obere Endposition des zweiten Ringes 30b‴.

Aufgrund der Anschlageinrichtung MO ist zudem der Anschluss A‴ für die Gasversorgungseinrichtung LV an anderer Stelle am zweiten Ring 30b‴ angebracht als bei der ersten und zweiten Ausführungsform.

Ansonsten ist die dritte Ausführungsform analog zur ersten Ausführungsform ausgestaltet.

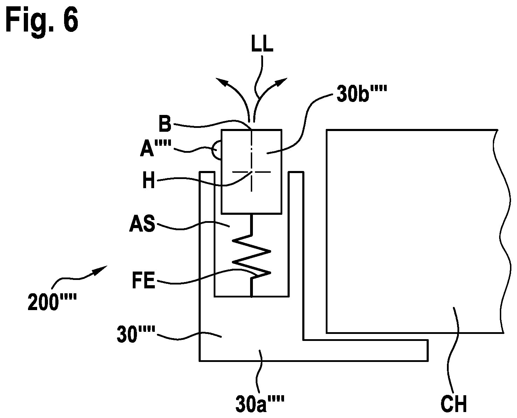

Fig. 6 zeigt eine teilweise Querschnittsdarstellung einer Waferproberanordnung mit einer Abschirmvorrichtung gemäß einer sechsten Ausführungsform der vorliegenden Erfindung.

Die Abschirmvorrichtung 200ʺʺ der fünften Ausführungsform unterscheidet sich von der Abschirmvorrichtung der ersten und zweiten Ausführungsform. Sie weist eine Ringeinrichtung 30ʺʺ mit einem ersten Ring 30aʺʺ und einem zweiten Ring 30bʺʺ auf.

Bei den vorherigen Ausführungsformen ist der zweite Ring an einer vom Chuck abgewandten oder dem Chuck zugewandten lateralen Seite des ersten Ringes verschieblich gelagert ist, welche im Wesentlichen parallel zur äußeren Peripherie des Chucks verläuft.

Beim der sechsten Ausführungsform hingegen ist der zweite Ring 30bʺʺ in einer Aussparung des ersten Ringes 30a‴ verschieblich gelagert.

Auch ist der Anschluss Aʺʺ für die Gasversorgungseinrichtung LV an anderer Stelle am zweiten Ring 30bʺʺ angebracht als bei der ersten bis fünften Ausführungsform.

Ansonsten ist die dritte Ausführungsform analog zur ersten Ausführungsform ausgestaltet.

Obwohl die vorliegende Erfindung vorstehend anhand bevorzugter Ausführungsformen erläutert wurde, ist sie nicht darauf beschränkt, sondern in vielfältiger Weise modifizierbar.

Insbesondere ist die geometrische Form der Abschirmvorrichtung nicht auf eine kreisringförmige Form beschränkt, sondern kann eine beliebige Geometrie annehmen. Auch sind die angegebenen Materialien der Abschirmvorrichtung nur beispielhaft und können in breitem Umfang variiert werden.

## Patentansprüche

1. Abschirmvorrichtung (200; 200'; 200"; 200‴; 200ʺʺ) für einen Chuck (CH) zur Abschirmung eines darauf in einem Waferprober (1) befindlichen Wafers (W), mit:
einer Ringeinrichtung (30; 30'; 30"; 30‴; 30ʺʺ) mit einem ersten Ring (30a; 30a'; 30a"; 30a‴; 30aʺʺ) und einem zweiten Ring (30b; 30b'; 30b"; 30b‴; 30bʺʺ);
wobei der erste Ring (30a; 30a'; 30a"; 30a‴; 30aʺʺ) an einer äußeren Peripherie (PP) von dem Chuck (CH) fest und im Wesentlichen fluiddicht anbringbar ist und der zweite Ring (30b; 30b'; 30b"; 30b‴; 30bʺʺ) entlang einer Höhenachse (HA) des Chucks (CH) verschieblich zum ersten Ring (30a; 30a'; 30a"; 30a‴; 30aʺʺ) an dem ersten Ring (30a; 30a'; 30a"; 30a‴; 30aʺʺ) gelagert ist; und
einer Vorspanneinrichtung (FE; PH) zum elastischen Vorspannen des zweiten Ringes (30b; 30b'; 30b"; 30b‴; 30bʺʺ) gegenüber dem ersten Ring (30a; 30a'; 30a"; 30a‴; 30aʺʺ) entlang der Höhenachse (HA) des Chucks (CH), so dass der zweite Ring (30b; 30b'; 30b"; 30b‴; 30bʺʺ) im an dem Chuck (CH) angebrachten Zustand über die Oberseite (OS) des auf den Chuck (CH) aufgelegten Wafers (W) vorsteht;
wobei der zweite Ring (30b; 30b'; 30b"; 30b‴; 30bʺʺ) einen Hohlraum (H) und damit kommunizierende Bohrungen (B) aufweist;
wobei der Hohlraum (H) einen Anschluss (A; A'; A"; A‴; Aʺʺ) zum Anschließen einer Gasversorgungseinrichtung (LV) aufweist; und
wobei über die Bohrungen (B) mittels der Gasversorgungseinrichtung (LV) ein Luftlager (LL) gegenüber einem plattenförmigen Gegenlager (20; 11b) oberhalb des zweiten Ringes (30b; 30b'; 30b"; 30b‴; 30bʺʺ) in Bezug auf die Höhenachse (HA) des Chucks (CH) erzeugbar ist;
wobei die Vorspanneinrichtung (FE; PH) durch das Luftlager (LL) derart komprimierbar ist, dass keine Berührung zwischen dem zweiten Ring (30b; 30b'; 30b"; 30b‴; 30bʺʺ) und dem plattenförmigen Gegenlager (20; 11b) auftritt; und
wobei der zweite Ring (30b; 30b'; 30b"; 30b‴) an einer vom Chuck (CH) abgewandten oder dem Chuck zugewandten lateralen Seite des ersten Ringes (30a; 30a'; 30a"; 30a‴) verschieblich gelagert ist, welche im Wesentlichen parallel zur äußeren Peripherie (PP) des Chucks verläuft;
wobei zwischen dem zweiten Ring (30b; 30b'; 30b") und dem ersten Ring (30a; 30a'; 30a") eine im Wesentlichen fluiddichte Gleitlagereinrichtung vorsehen ist.

2. Abschirmvorrichtung (200ʺʺ) nach Anspruch 1, wobei der zweite Ring (30bʺʺ) in einer Aussparung (AS) des ersten Ringes (30a‴) verschieblich gelagert ist.

3. Abschirmvorrichtung (200; 200'; 200"; 200‴; 200ʺʺ) nach einem der vorhergehenden Ansprüche, wobei die Vorspanneinrichtung (FE; PH) eine Federeinrichtung (FE) aufweist, welche sich auf dem ersten Ring (30a; 30a'; 30a"; 30a‴; 30aʺʺ) und dem zweiten Ring (30b; 30b'; 30b"; 30b‴; 30bʺʺ) abstützt.

4. Abschirmvorrichtung (200; 200'; 200"; 200‴; 200ʺʺ) nach einem der vorhergehenden Ansprüche, wobei die Vorspanneinrichtung (FE; PH) eine pneumatische Hubeinrichtung (PH) aufweist, über die der zweite Ring (30b") gegenüber dem ersten Ring (30a") anhebbar und absenkbar ist.

5. Abschirmvorrichtung (200; 200'; 200"; 200‴; 200ʺʺ) nach Anspruch 4, wobei die pneumatische Hubeinrichtung (PH) an dem ersten Ring (30a; 30a'; 30a"; 30a‴; 30aʺʺ) angebracht ist und über eine Hubstange (HS) mit dem zweiten Ring (30b; 30b'; 30b"; 30b‴; 30bʺʺ) verbunden ist.

6. Abschirmvorrichtung (200; 200'; 200"; 200‴; 200ʺʺ) nach einem der vorhergehenden Ansprüche, wobei eine Anschlageinrichtung (BL; MO) vorgesehen ist, welche eine Verschiebung des zweiten Ringes (30b; 30b'; 30b"; 30b‴; 30bʺʺ) entlang einer Höhenachse (HA) des Chucks (CH) zum ersten Ring (30a; 30a'; 30a"; 30a‴; 30aʺʺ) begrenzt.

7. Abschirmvorrichtung (200; 200'; 200"; 200‴; 200ʺʺ) nach Anspruch 6, wobei die Anschlageinrichtung (MO) verstellbar ist.

8. Abschirmvorrichtung (200; 200'; 200"; 200‴; 200ʺʺ) nach einem der vorhergehenden Ansprüche, wobei Ringeinrichtung (30; 30'; 30"; 30‴; 30ʺʺ) aus einem elektrischen oder magnetischen Abschirmmaterial gebildet ist.

9. Chuck (CH) mit einer Abschirmvorrichtung (200; 200'; 200"; 200‴; 200ʺʺ) nach einem der vorhergehenden Ansprüche oder in den eine Abschirmvorrichtung (200; 200'; 200"; 200‴; 200ʺʺ) nach einem der vorhergehenden Ansprüche integriert ist.

10. Waferproberanordnung mit:
einem Oberteil (1a) und einem Unterteil (1b), wobei das Unterteil (1b) einen Innenraum (I) aufweist;
einem Chuck (CH), der in dem Innenraum (I) vorgesehen ist, welcher eine Abschirmvorrichtung (200; 200'; 200"; 200"'; 200ʺʺ) nach einem der Ansprüche 1 bis 8 aufweist;
einer Probecard (5), welche im oberen Bereich des Unterteils (1b) aufgehängt ist;
wobei auf der dem Innenraum (I) zugewandten Seite der Probecard (5) ein Nadelkopf (10) mit einer daran angebrachten Nadeleinrichtung (10A) zum Kontaktieren elektronischer Schaltungen auf einem Testwafer (W) vorgesehen ist, welcher von der Probecard (5) nach unten in den Innenraum (I) hinein vorsteht;
wobei der Chuck (CH) in lateralen Richtungen (x, y) und in Höhenrichtung (z) entsprechend einer Vielzahl von Testpositionen auf dem Testwafer (W) verstellbar ist; und
wobei die Abschirmvorrichtung (200; 200'; 200"; 200‴; 200ʺʺ) derart vorgesehen ist, dass sie eine Abschirmung der Vielzahl von Testpositionen auf dem Testwafer (W) gewährleistet.

11. Waferproberanordnung nach Anspruch 10, wobei eine Innenfläche (11b) des oberen Bereichs des Unterteils (1b) das plattenförmige Gegenlager (20; 11b) für die Abschirmvorrichtung (200; 200'; 200"; 200‴; 200ʺʺ) bildet.

12. Waferproberanordnung nach Anspruch 10, wobei an einer Innenfläche (11b) des oberen Bereichs des Unterteils (1b) eine Abschirmplatte (20) über eine dichtende Befestigungseinrichtung (25) mit dem oberen Bereich des Unterteils (1b) verbunden ist, welche eine Durchgangsöffnung (20a) für die Nadeleinrichtung (10A) aufweist; wobei die Abschirmplatte (20) das plattenförmige Gegenlager (20; 11b) für die Abschirmvorrichtung (200; 200'; 200"; 200‴; 200ʺʺ) bildet.

13. Waferproberanordnung nach einem der Ansprüche 10 bis 12, wobei sich der Chuck (CH) auf einem Sockel (S) befindet, welcher über eine programmierbare Steuerung in x-, y- und z-Richtung verfahrbar ist, so dass die Vielzahl von Testpositionen auf dem Testwafer (W) durch den Chuck (CH) automatisch anfahrbar ist.

## Claims

1. Shielding device (200; 200'; 200"; 200‴; 200ʺʺ) for a chuck (CH) for shielding a wafer (W) located thereon in a wafer prober (1), having:
a ring device (30; 30'; 30"; 30‴; 30ʺʺ) with a first ring (30a; 30a'; 30a"; 30a‴; 30aʺʺ) and a second ring (30b; 30b'; 30b"; 30b‴; 30bʺʺ);
wherein the first ring (30a; 30a'; 30a"; 30a‴; 30aʺʺ) can be secured to an outer periphery (PP) of the chuck (CH) in a fixed and substantially fluid-tight manner and the second ring (30b; 30b'; 30b"; 30b‴; 30bʺʺ) is mounted on the first ring (30a; 30a'; 30a"; 30a‴; 30aʺʺ) so as to be displaceable along a height axis (HA) of the chuck (CH) relative to the first ring (30a; 30a'; 30a"; 30a‴; 30aʺʺ); and
a biasing device (FE; PH) for elastically biasing the second ring (30b; 30b'; 30b"; 30b‴; 30bʺʺ) relative to the first ring (30a; 30a'; 30a"; 30a‴; 30aʺʺ) along the height axis (HA) of the chuck (CH), such that the second ring (30b; 30b'; 30b"; 30b"'; 30b"") protrudes beyond the upper side (OS) of the wafer placed onto the chuck (CH) when attached to the chuck (CH);
wherein the second ring (30b; 30b'; 30b"; 30b‴; 30bʺʺ) has a cavity (H) and bores (B) communicating therewith;
wherein the cavity (H) has a connection (A; A'; A"; A‴; Aʺʺ) for connecting a gas supply device (LV); and
wherein an air bearing (LL) can be generated via the bores (B) by means of the gas supply device (LV) relative to a plate-shaped counter-bearing (20; 11b) above the second ring (30b; 30b'; 30b"; 30b‴; 30bʺʺ) with respect to the height axis (HA) of the chuck (CH);
wherein the biasing device (FE; PH) can be compressed by the air bearing (LL) in such a way that no contact occurs between the second ring (30b; 30b'; 30b"; 30b‴; 30bʺʺ) and the plate-shaped counter-bearing (20; 11b); and
wherein the second ring (30b; 30b'; 30b"; 30b‴) is displaceably mounted on a lateral side of the first ring (30a; 30a'; 30"; 30a‴) facing away from the chuck (CH) or facing the chuck, which runs substantially parallel to the outer periphery (PP) of the chuck;
wherein a substantially fluid-tight plain bearing device is provided between the second ring (30b; 30b'; 30b") and the first ring (30a; 30a'; 30a").

2. Shielding device (200ʺʺ) according to claim 1, wherein the second ring (30bʺʺ) is displaceably mounted in a recess (AS) of the first ring (30a‴).

3. Shielding device (200; 200'; 200"; 200‴; 200ʺʺ) according to one of the preceding claims, wherein the biasing device (FE; PH) has a spring device (FE), which is supported on the first ring (30a; 30a'; 30a"; 30a‴; 30aʺʺ) and the second ring (30b; 30b'; 30b"; 30b‴; 30bʺʺ).

4. Shielding device (200; 200'; 200"; 200‴; 200ʺʺ) according to one of the preceding claims, wherein the biasing device (FE; PH) has a pneumatic lifting device (PH), via which the second ring (30b") can be raised and lowered relative to the first ring (30a").

5. Shielding device (200; 200'; 200"; 200‴; 200ʺʺ) according to claim 4, wherein the pneumatic lifting device (PH) is attached to the first ring (30a; 30a'; 30a"; 30a‴; 30aʺʺ) and connected to the second ring (30b; 30b'; 30b"; 30b‴; 30bʺʺ) via a lifting rod (HS).

6. Shielding device (200; 200'; 200"; 200‴; 200ʺʺ) according to one of the preceding claims, wherein a stop device (BL; MO) is provided, which limits movement of the second ring (30b; 30b'; 30b"; 30b‴; 30bʺʺ) along a height axis (HA) of the chuck (CH) relative to the first ring (30a; 30a'; 30a"; 30a‴; 30aʺʺ).

7. Shielding device (200; 200'; 200"; 200‴; 200ʺʺ) according to claim 6, wherein the stop device (MO) is adjustable.

8. Shielding device (200; 200'; 200"; 200"'; 200ʺʺ) according to one of the preceding claims, wherein the ring device (30; 30'; 30"; 30‴; 30ʺʺ) is formed from an electrical or magnetic shielding material.

9. Chuck (CH) having a shielding device (200; 200'; 200"; 200‴; 200ʺʺ) according to one of the preceding claims or in which a shielding device (200; 200'; 200"; 200‴; 200ʺʺ) according to one of the preceding claims is integrated.

10. Wafer prober assembly having:
an upper part (1a) and a lower part (1b), wherein the lower part (1b) has an interior (I);
a chuck (CH), which is provided in the interior (I), which has a shielding device (200; 200'; 200"; 200‴; 200ʺʺ) according to one of claim 1 to 8;
a probe card (5), which is suspended in the upper region of the lower part (1b);
wherein, on the side of the probe card (5) facing the interior (I), a needle head (10) is provided with a needle device (10A) attached thereto for contacting electronic circuits on a test wafer (W), which protrudes downwards from the probe card (5) into the interior (I);
wherein the chuck (CH) can be adjusted in lateral directions (x, y) and in the height direction (z) in accordance with a plurality of test positions on the test wafer (W); and
wherein the shielding device (200; 200'; 200"; 200‴; 200ʺʺ) is provided in such a manner that it ensures shielding of the plurality of test positions on the test wafer (W).

11. Wafer prober assembly according to claim 10, wherein an inner surface (11b) of the upper region of the lower part (1b) forms the plate-shaped counter-bearing (20; 11b) for the shielding device (200; 200'; 200"; 200‴; 200ʺʺ).

12. Wafer prober assembly according to claim 10, wherein on an inner surface (11b) of the upper region of the lower part (1b), a shielding plate (20) is connected to the upper region of the lower part (1b) via a sealing fastening device (25), and has a through-opening for the needle device (10A); wherein the shielding plate (20) forms the plate-shaped counter-bearing (20; 11b) for the shielding device (200; 200'; 200"; 200‴; 200ʺʺ).

13. Wafer prober assembly according to one of claims 10 to 12, wherein the chuck (CH) is located on a base (S), which can be displaced in an x-, y- and z-direction via a programmable control system, such that the chuck (CH) can automatically move to the plurality of test positions on the test wafer (W).

## Revendications

1. Dispositif de blindage (200 ; 200' ; 200" ; 200‴ ; 200ʺʺ) pour un mandrin (CH) destiné à blinder une plaquette (W) qui est située dans un testeur de plaquettes (1), comprenant :
un dispositif à bagues (30 ; 30' ; 30" ; 30'" ; 30ʺʺ) comprenant une première bague (30a ; 30a' ; 30a" ; 30a"' ; 30aʺʺ) et une deuxième bague (30b ; 30b' ; 30b" ; 30b'" ; 30bʺʺ) ;
dans lequel la première bague (30a ; 30a' ; 30a" ; 30a'" ; 30aʺʺ) peut être fixée de manière rigide et essentiellement étanche aux fluides sur une périphérie extérieure (PP) du mandrin (CH) et la deuxième bague (30b ; 30b' ; 30b" ; 30b‴ ; 30bʺʺ) est montée sur la première bague (30a ; 30a' ; 30a" ; 30a"' ; 30aʺʺ) de manière à pouvoir coulisser par rapport à la première bague (30a ; 30a' ; 30a" ; 30a"' ; 30aʺʺ) le long d'un axe de hauteur (HA) du mandrin (CH) ; et
un dispositif de précontrainte (FE ; PH) destiné à précontraindre élastiquement la deuxième bague (30b ; 30b' ; 30b" ; 30b‴ ; 30bʺʺ) par rapport à la première bague (30a ; 30a' ; 30a" ; 30a'" ; 30a"") le long de l'axe de hauteur (HA) du mandrin (CH), de sorte que la deuxième bague (30b ; 30b' ; 30b" ; 30b'" ; 30bʺʺ) fait saillie, à l'état fixé sur le mandrin (CH), de la face supérieure (OS) de la plaquette (W) posée sur le mandrin (CH) ;
dans lequel la deuxième bague (30b ; 30b' ; 30b" ; 30b‴ ; 30b"") présente une cavité (H) et des alésages (B) communiquant avec celle-ci ;
dans lequel la cavité (H) présente un raccord (A ; A' ; A" ; A‴ ; A"") pour le raccordement d'un dispositif d'alimentation en gaz (LV) ; et
dans lequel, par l'intermédiaire des alésages (B) et au moyen du dispositif d'alimentation en gaz (LV), un palier à air (LL) peut être généré par rapport à un contre-appui en forme de plaque (20 ; 11 b) au-dessus de la deuxième bague (30b ; 30b' ; 30b" ; 30b'" ; 30b"") par rapport à l'axe de hauteur (HA) du mandrin (CH) ;
dans lequel le dispositif de précontrainte (FE ; PH) peut être comprimé par le palier à air (LL) de telle sorte qu'il n'y ait aucun contact entre la deuxième bague (30b ; 30b' ; 30b" ; 30b‴ ; 30bʺʺ) et le contre-appui en forme de plaque (20 ; 11b) ; et
dans lequel la deuxième bague (30b ; 30b' ; 30b" ; 30b'" ; 30bʺʺ) est montée de manière coulissante sur un côté latéral de la première bague (30a ; 30a' ; 30a" ; 30a‴) qui est tourné à l'opposé du mandrin (CH) ou vers le mandrin et qui s'étend essentiellement parallèlement à la périphérie extérieure (PP) du mandrin ;
dans lequel, entre la deuxième bague (30b ; 30b' ; 30b") et la première bague (30a ; 30a' ; 30a") est prévu un dispositif de palier lisse essentiellement étanche aux fluides.

2. Dispositif de blindage (200"") selon la revendication 1, dans lequel la deuxième bague (30bʺʺ) est montée de manière coulissante dans un évidement (AS) de la première bague (30a‴).

3. Dispositif de blindage (200 ; 200' ; 200" ; 200"' ; 200"") selon l'une des revendications précédentes, dans lequel le dispositif de précontrainte (FE ; PH) présente un dispositif à ressort (FE) qui s'appuie sur la première bague (30a ; 30a' ; 30a" ; 30a'" ; 30a"") et sur la deuxième bague (30b ; 30b' ; 30b" ; 30b‴ ; 30bʺʺ).

4. Dispositif de blindage (200 ; 200' ; 200" ; 200‴ ; 200" ") selon l'une des revendications précédentes, dans lequel le dispositif de précontrainte (FE ; PH) présente un dispositif de levage pneumatique (PH) permettant de lever et d'abaisser la deuxième bague (30b") par rapport à la première bague (30a").

5. Dispositif de blindage (200 ; 200' ; 200" ; 200‴ ; 200"") selon la revendication 4, dans lequel le dispositif de levage pneumatique (PH) est fixé sur la première bague (30a ; 30a' ; 30a" ; 30a‴ ; 30aʺʺ) et est relié à la deuxième bague (30b ; 30b' ; 30b" ; 30b'" ; 30bʺʺ) par l'intermédiaire d'une tige de levage (HS).

6. Dispositif de blindage (200 ; 200' ; 200" ; 200"' ; 200"") selon l'une des revendications précédentes, dans lequel il est prévu un dispositif de butée (BL ; MO) qui limite un déplacement de la deuxième bague (30b ; 30b' ; 30b" ; 30b‴ ; 30bʺʺ) par rapport à la première bague (30a ; 30a' ; 30a" ; 30a"' ; 30aʺʺ) le long d'un axe de hauteur (HA) du mandrin (CH).

7. Dispositif de blindage (200 ; 200' ; 200" ; 200‴ ; 200ʺʺ) selon la revendication 6, dans lequel le dispositif de butée (MO) est réglable.

8. Dispositif de blindage (200 ; 200' ; 200" ; 200'" ; 200ʺʺ) selon l'une des revendications précédentes, dans lequel le dispositif à bagues (30 ; 30' ; 30" ; 30'" ; 30"') est formé d'un matériau de blindage électrique ou magnétique.

9. Mandrin (CH) comprenant un dispositif de blindage (200 ; 200' ; 200" ; 200‴ ; 200ʺʺ) selon l'une des revendications précédentes ou dans lequel est intégré un dispositif de blindage (200 ; 200' ; 200" ; 200‴ ; 200"") selon l'une des revendications précédentes.

10. Agencement de test de plaquettes comprenant :
une partie supérieure (1a) et une partie inférieure (1b), la partie inférieure (1b) présentant un espace intérieur (I) ;
un mandrin (CH) prévu dans l'espace intérieur (I), lequel présente un dispositif de blindage (200 ; 200' ; 200" ; 200‴ ; 200"") selon l'une des revendications 1 à 8 ;
une carte de test (5) suspendue dans la zone supérieure de la partie inférieure (1b) ;
dans lequel une tête d'aiguilles (10) est prévue sur le côté de la carte de test (5) tourné vers l'espace intérieur (I), sur laquelle est fixé un dispositif à aiguilles (10A) pour entrer en contact avec des circuits électroniques sur une plaquette de test (W) et laquelle fait saillie vers le bas dans l'espace intérieur (I) depuis la carte de test (5) ;
dans lequel le mandrin (CH) est réglable dans les directions latérales (x, y) et dans la direction de hauteur (z) en fonction d'une pluralité de positions de test sur la plaquette de test (W) ; et
dans lequel le dispositif de blindage (200 ; 200' ; 200" ; 200‴ ; 200"") est prévu de manière à assurer un blindage de la pluralité de positions de test sur la plaquette de test (W).

11. Agencement de test de plaquettes selon la revendication 10, dans lequel une surface intérieure (11b) de la zone supérieure de la partie inférieure (1b) forme le contre-appui en forme de plaque (20 ; 11b) pour le dispositif de blindage (200 ; 200' ; 200" ; 200‴ ; 200"").

12. Agencement de test de plaquettes selon la revendication 10, dans lequel une plaque de blindage (20), qui présente une ouverture de passage (20a) pour le dispositif à aiguilles (10A), est reliée à la zone supérieure de la partie inférieure (1b) au niveau d'une surface intérieure (11b) de ladite zone supérieure de la partie inférieure (1b) par l'intermédiaire d'un dispositif de fixation étanche (25) ; dans lequel la plaque de blindage (20) forme le contre-appui en forme de plaque (20 ; 11b) pour le dispositif de blindage (200 ; 200' ; 200" ; 200‴ ; 200ʺʺ).

13. Agencement de test de plaquettes selon l'une des revendications 10 à 12, dans lequel le mandrin (CH) est situé sur un socle (S) qui peut être déplacé dans les directions x, y et z via une commande programmable, de sorte que la pluralité de positions de test sur la plaquette de test (W) peut être atteinte automatiquement par le mandrin (CH).
